# EUROPEAN PATENT APPLICATION

(11) **EP 3 051 585 A1**
(43) Date of publication of application: **03.08.2016**
(21) Application number: 15191914.9
(22) Date of filing: 28.10.2015
(51) Int. Cl.: H01L 23/50, H01L 23/538

(54) **CHIP PACKAGE WITH EMBEDDED PASSIVE DEVICE**

(30) Priority: 27.01.2015 US 201562108159 P; 23.10.2015 US 201514920883
(71) Applicant: MediaTek, Inc, Hsin-Chu 300 (TW)
(72) Inventor: CHANG, Po-Hao, 235 New Taipei City (TW); CHANG, Chun-Wei, 104 Taipei City (TW); LI, Ching-Chih, 231 New Taipei City (TW)
(74) Representative: Hoefer & Partner Patentanwälte mbB

(57) **Abstract**

A chip package includes a first die encapsulated by a molding compound; a board comprising a chip mounting surface; a redistributed layer (RDL) structure on an active surface of the first die and between the die and the chip mounting surface; and a discrete passive device embedded within the chip package and situated in close proximity to a side edge of the first die.

## Description

### Background

The present invention relates to an improved integrated circuit (IC) chip package with an embedded, discrete passive device that is capable of reducing on-chip IR drop.

An integrated circuit (IC) device typically includes an IC chip or die that is housed in a package. The IC chip typically includes a circuit fabricated by lithographically patterning conductive and insulating materials on a thin wafer of semiconductor using known fabrication techniques. The package supports and protects the IC chip and provides electrical connections between the circuit and an external circuit board. Several known package types are used to house IC chips, such as ball grid arrays (BGAs), pin grid arrays (PGAs), plastic leaded chip carriers, plastic quad flat packs and others, for example.

A ball grid array (BGA) package is known in the art. A BGA package is joined to a mounting board by use of conductive balls (bumps) arranged in an array on its back as external terminals, instead of using a lead frame. Because the entire back surface of the semiconductor package can be used for connection to the board, the number of input/output pads can be markedly increased. To support higher functionality, the number of pins has remarkably increased.

One type of an IC chip package is a "flip chip", which does not require any wire bonds. After cutting the wafer into individual dice, the "flip chip" is mounted upside down on a package substrate, which contains matching contact points and connections to the associated external circuitry. The solder is reflowed in order to bond the contacts of the chip and the substrate. Flip chips then normally undergo an under fill process and an encapsulation process which covers the sides of the die.

As system complexity and operational speeds increase, the power consumption of integrated circuits increases dramatically. Additionally, the IC supply voltage continues to drop with the inevitable scaling of VLSI technology. Reducing the nominal supply voltage is accompanied by a reduction in device noise margins, making components more vulnerable to power supply noise. This noise consists of the dynamic AC voltage fluctuation due to the frequency dependent distributed parasitics inherent in today's power distribution systems, and the DC voltage drop (i.e., "IR" drop).

In a microelectronic system, the system's IR drop may be budgeted into three portions: on-chip, package and board. On-chip IR drop has been extensively studied because the resistive loss is severe due to the fine feature-size of the on-die power grid. Typically, to reduce the on-chip IR drop, metal-insulator-metal (MIM) capacitors are formed in the metal interconnection of an integrated circuit die. However, to maintain adequate capacitance, the size of the on-die MIM capacitor does not shrink as the size of the IC decreases. Therefore, the ratio of chip area occupied by the on-die capacitor gradually increases, which translates into increased cost.

### Summary

This in mind, the present invention aims at providing an improved chip package with an embedded, discrete passive device that is capable of reducing on-chip IR drop.

This is achieved by a chip package according to the pre-characterizing clause of claim 1. The dependent claims pertain to corresponding further developments and improvements.

As will be seen more clearly from the detailed description following below, the claimed chip package includes a first die encapsulated by a molding compound; a board comprising a chip mounting surface; a redistributed layer (RDL) structure on an active surface of the first die and between the first die and the chip mounting surface; and a discrete passive device embedded in the molding compound and situated in close proximity to a side edge of the first die.

According to one embodiment, the chip package further comprises a second die. The first and second dies are arranged side-by-side and are encapsulated together by the molding compound. The RDL structure is also disposed on an active surface of the second die. According to one embodiment, an edge-to-edge distance between the first die and the second die is equal to or greater than 1000 micrometers.

According to one embodiment, the discrete passive device has a surface that is substantially flush with the active surface of the first die and the active surface of the second die, wherein the RDL structure is also disposed directly on the surface.

According to another aspect of the invention, a chip package includes a first die encapsulated by a molding compound; a board comprising a chip mounting surface; an RDL structure on an active surface of the first die and between the die and the chip mounting surface; and a discrete passive device embedded in the RDL structure.

According to another aspect of the invention, a chip package includes a semiconductor die; a board comprising a chip mounting surface; an RDL structure on an active surface of the semiconductor die and between the semiconductor die and the chip mounting surface; and a discrete passive device embedded in the RDL structure.

These and other objectives of the present invention will no doubt become obvious to those of ordinary skill in the art after reading the following detailed description of the preferred embodiment that is illustrated in the various figures and drawings.

### Brief Description of the Drawings

In the following, the invention is further illustrated by way of example, taking reference to the accompanying drawings. Thereof
FIG. 1 illustrates a cross-sectional representation of a chip package according to one embodiment of the invention;
FIG. 2 is a schematic, cross-sectional diagram showing a chip package according to another embodiment of the invention;
FIG. 3 is a schematic, cross-sectional diagram showing a chip package according to another embodiment of the invention; and
FIG. 4 is a schematic, cross-sectional diagram showing a flip-chip BGA (FCBGA) package according to still another embodiment of the invention.

### Detailed Description

In the following detailed description of embodiments of the invention, reference is made to the accompanying drawings, which form a part hereof, and in which is shown by way of illustration specific preferred embodiments in which the disclosure may be practiced.

These embodiments are described in sufficient detail to enable those skilled in the art to practice them, and it is to be understood that other embodiments may be utilized and that mechanical, chemical, electrical, and procedural changes may be made without departing from the spirit and scope of the present disclosure.

The following detailed description is, therefore, not to be taken in a limiting sense, and the scope of embodiments of the present invention is defined only by the appended claims.

The present invention pertains to an improved chip package with at least one embedded, discrete passive device that is disposed in close proximity to the IC die in the chip package. The embedded, thin passive device is capable of reducing on-chip IR drop.

From one aspect of the invention, the embedded, discrete passive device may be used to replace the expensive on-chip MIM capacitor. Compared to the conventional large-area, on-chip MIM capacitor, the embedded, discrete passive device is still able to achieve large enough magnitude capacitance for decoupling purposes but with reduced cost.

By embedding the embedded, discrete passive device into the chip package, when an IR drop near the chip or die occurs, the discrete passive device can rapidly compensate the undesired IR drop to hence prevent the chip or die from being affected. In addition, the embedded, discrete passive device further keeps the die away from the unwanted power noise.

According to one illustrative embodiment of the invention, the chip package may be a fan-out wafer-level package (Fan-out WLP), but not limited thereto. Fan-out WLP promises superior form factor, pin count, and thermal performance to existing flip-chip ball grid array (FC-BGA) packages. In addition, Fan-out WLP's high Q inductors can enhance electrical performance and lower power consumption in RF circuit applications.

Further, Fan-out WLP provides a thinner package with much tighter RDL pitch. In Fan-out WLP, copper interconnects, known as PPI (post passivation interconnection), are formed over the exposed on-chip pads.

It is noted that in one illustrative embodiment of the invention, the discrete passive device can be decoupling capacitor that is able to achieve large enough magnitude capacitance and rapidly compensate the undesired IR drop. However, in other illustrative embodiments, the discrete passive device can be resistor, inductor, RF filter, diode or combination for different purposes, which is not limited.

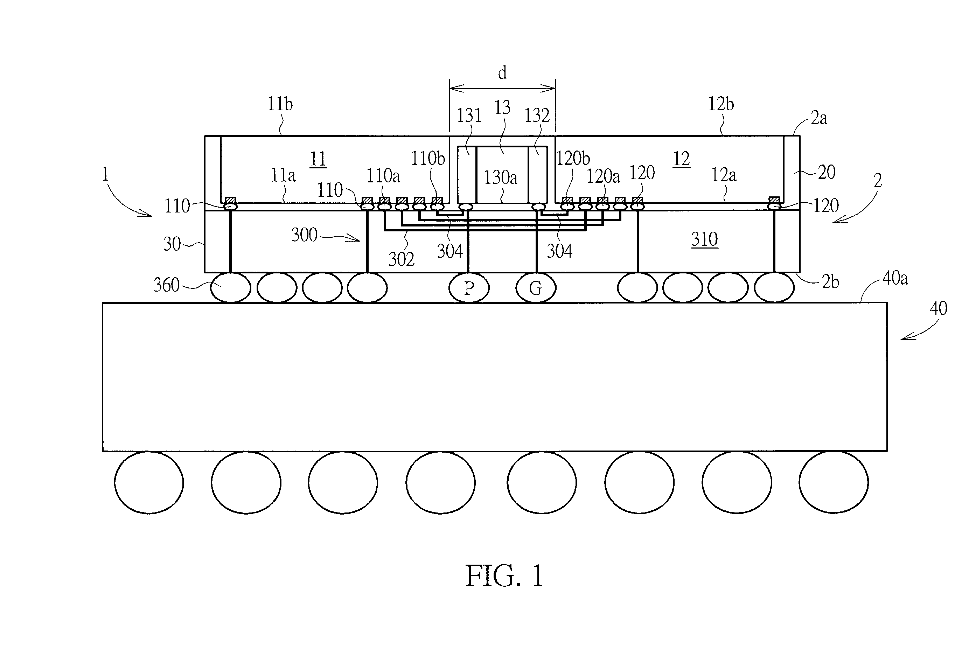

FIG. 1 illustrates a cross-sectional representation of a chip package according to one exemplary embodiment of the invention. As shown in FIG. 1, the chip package 1 may comprise multiple IC chips or dies (in this example, two dies) 11 and 12 that are molded together in one WLP package 2.

According to the illustrated embodiment, the two dies 11 and 12 are arranged side-by-side and are encapsulated by a molding compound 20. An active surface 11 a of the die 11 and an active surface 12a of the die 12 are flipped and are assembled face-down to a chip mounting surface 40a of a board 40 such as a packaging substrate or a printed circuit board.

According to the illustrated embodiment, a bottom surface 11b of the die 11 and a bottom surface 12b of the die 12 may be exposed from a top surface 2a of the WLP package 2.

According to the illustrated embodiment, a plurality of fine-pitch connection points 110 such as conductive pads or micro bumps may be distributed on the active surface 11 a of the die 11 and a plurality of fine-pitch connection points 120 such as conductive pads or micro bumps may be distributed on the active surface 12a of the die 12.

According to the illustrated embodiment, the WLP package 2 may further comprise a redistributed layer (RDL) structure 30 between the die 11/12 and the chip mounting surface 40a of the board 40. The RDL structure 30 fans out the fine-pitch connection points 110 and the fine-pitch connection points 120 to a looser pad pitch.

Interconnection scheme 300 may be fabricated in the RDL structure 30 to redistribute the plurality of fine-pitch connection points 110 and the plurality of fine-pitch connection points 120 to a bottom surface 2b of the WLP package 2. A plurality of bumps 360 is disposed on the bottom surface 2b of the WLP package 2 to electrically connect the WLP package 2 with the board 40. According to the illustrated embodiment, the interconnection scheme 300 may comprise copper post-passivation interconnection (Cu-PPI) scheme.

According to the illustrated embodiment, the interconnection scheme 300 may comprise interconnection traces 302 for interconnecting the die-to-die signal points 110a on the active surface 11 a of the die 11 with the die-to-die signal points 120a on the active surface 12a of the die 12. The RDL structure 30 may further comprise at least one polymeric insulating layer 310 such as polyimide or epoxy, but not limited thereto.

According to the illustrated embodiment, the chip package 1 further comprises a discrete passive device 130 interposed between the die 11 and the die 12. The discrete passive device 130 is molded together with the two dies 11 and 12 within the molding compound 20.

According to the illustrated embodiment, to accommodate the discrete passive device 130, a gap having an edge-to-edge distance d between the two dies 11 and 12 is provided. For example, the distance d may be equal to or greater than 1000 micrometers, but not limited thereto. The discrete passive device 130 is disposed in close proximity to the side edges of the two dies 11 and 12.

Although only one passive device 130 is shown in the illustrative embodiment, it is to be understood that a plurality of discrete passive devices may be arranged in a row within the gap according to another embodiment. The orientation of the passive device 130 in figures is for illustration purposes only.

According to the illustrated embodiment, the discrete passive device 130 has a surface 130a that is substantially flush with the active surface 11a of the die 11 and the active surface 12a of the die 12, such that the RDL structure 30 may be formed directly on the surface 130a.

According to the illustrated embodiment, the discrete passive device 130 has two terminals 131 and 132, which may be electrically connected to ground/power points 110b and 120b respectively, on the active surface 11 a of the die 11 and the active surface 12a of the die 12 through the interconnection traces 304.

For example, the two terminals 131 and 132 are electrically connected to ground pads and power pads respectively on the active surface 11 a of the die 11 through the interconnection traces 304. For example, the two terminals 131 and 132 are electrically connected to ground pads and power pads respectively on the active surface 12a of the die 12 through the interconnection traces 304.

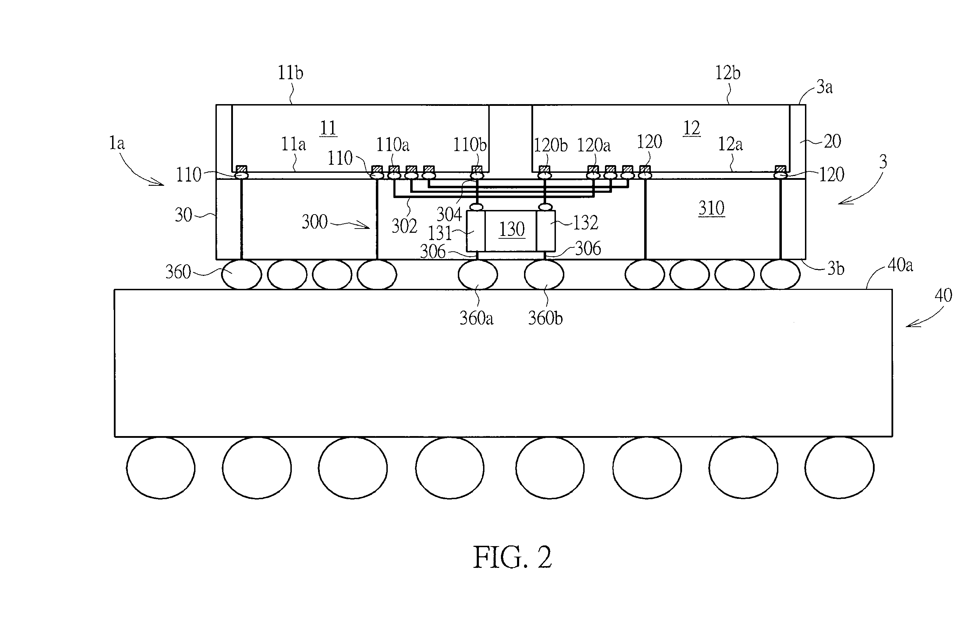

FIG. 2 is a schematic, cross-sectional diagram showing a chip package according to another embodiment of the invention, wherein like numeral numbers designate like regions, layers, or elements. As shown in FIG. 2, the chip package 1a may comprise multiple IC chips or dies (in this example, two dies) 11 and 12 that are molded together in one WLP package 3.

According to the illustrated embodiment, the two dies 11 and 12 are arranged side-by-side and are encapsulated by a molding compound 20. An active surface 11 a of the die 11 and an active surface 12a of the die 12 are flipped and are assembled face-down to a chip mounting surface 40a of a board 40 such as a packaging substrate or a printed circuit board.

According to the illustrated embodiment, a bottom surface 11b of the die 11 and a bottom surface 12b of the die 12 may be exposed from a top surface 3a of the WLP package 3.

According to the illustrated embodiment, a plurality of fine-pitch connection points 110 such as conductive input/output (I/O) pads or micro bumps may be distributed on the active surface 11 a of the die 11 and a plurality of fine-pitch connection points 120 such as conductive pads or micro bumps may be distributed on the active surface 12a of the die 12.

According to the illustrated embodiment, the WLP package 3 may further comprise a RDL structure 30 between the die 11/12 and the chip mounting surface 40a of the board 40. The RDL structure 30 fans out the fine-pitch connection points 110 and the fine-pitch connection points 120 to a looser pad pitch.

Interconnection scheme 300 may be fabricated in the RDL structure 30 to redistribute the plurality of fine-pitch connection points 110 and the plurality of fine-pitch connection points 120 to a bottom surface 3b of the WLP package 3. A plurality of bumps 360 is disposed on the bottom surface 3b of the WLP package 3 to electrically connect the WLP package 3 with the board 40. According to the illustrated embodiment, the interconnection scheme 300 may comprise copper post-passivation interconnection (Cu-PPI) scheme.

According to the illustrated embodiment, the interconnection scheme 300 may comprise interconnection traces 302 for interconnecting the die-to-die signal points 110a on the active surface 11 a of the die 11 with the die-to-die signal points 120a on the active surface 12a of the die 12. The RDL structure 30 may further comprise at least one polymeric insulating layer 310 such as polyimide or epoxy, but not limited thereto.

According to the illustrated embodiment, the chip package 1a further comprises a discrete passive device 130 embedded within the RDL structure 30. For example, the discrete passive device 130 may be mounted within a cavity that is recessed into the bottom surface 3b of the WLP package 3, but not limited thereto.

According to the illustrated embodiment, the discrete passive device 130 has two terminals 131 and 132, which may be electrically connected to ground/power points 110b and 120b respectively, on the active surface 11 a of the die 11 and the active surface 12a of the die 12 through the interconnection traces 304. The two terminals 131 and 132 may be electrically connected to respective ground/power bumps 360a and 360b through the interconnection traces 306. For example, the two terminals 131 and 132 are electrically connected to ground pads and power pads respectively on the active surface 11a of the die 11 through the interconnection traces 304. For example, the two terminals 131 and 132 are electrically connected to ground pads and power pads respectively on the active surface 12a of the die 12 through the interconnection traces 304.

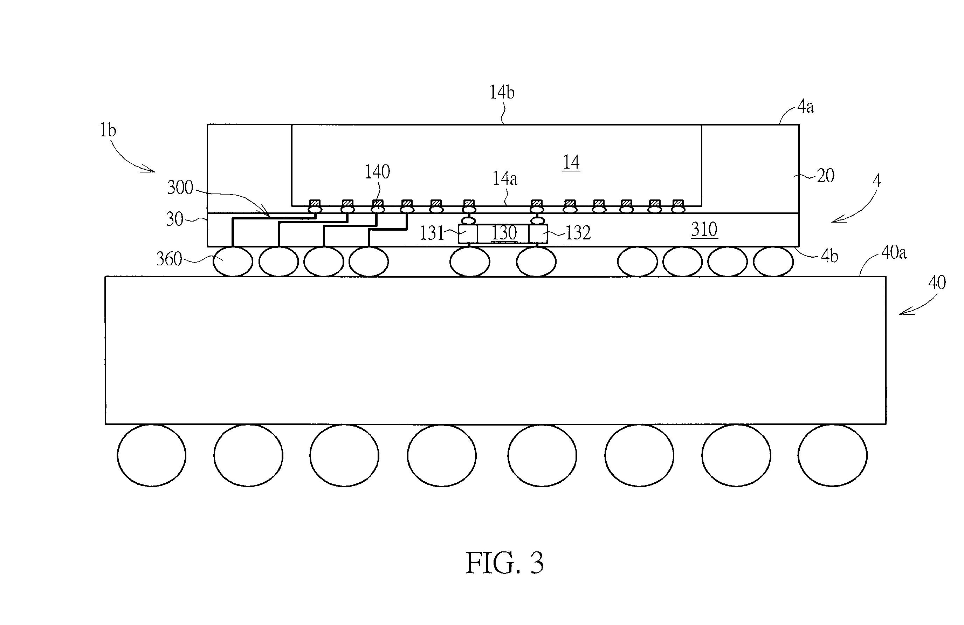

FIG. 3 is a schematic, cross-sectional diagram showing a chip package according to another embodiment of the invention, wherein like numeral numbers designate like regions, layers, or elements. As shown in FIG. 3, the chip package 1b may comprise a single IC chip or die 14 encapsulated in a molding compound 20 to form a WLP package 4.

According to the illustrated embodiment, an active surface 14a of the die 14 is flipped and is assembled face-down to a chip mounting surface 40a of a board 40 such as a packaging substrate or a printed circuit board. According to the illustrated embodiment, a bottom surface 14b of the die 14 may be exposed from a top surface 4a of the WLP package 4.

According to the illustrated embodiment, a plurality of fine-pitch connection points 140 such as conductive pads or micro bumps may be distributed on the active surface 14a of the die 14. An RDL structure 30 is disposed between the die 14 and the chip mounting surface 40a of the board 40. The RDL structure 30 fans out the fine-pitch connection points 140 to a looser pad pitch on a bottom surface 4b of the WLP package 4.

Likewise, interconnection scheme 300 may be fabricated in the RDL structure 30 to redistribute the plurality of fine-pitch connection points 140 to the bottom surface 4b of the WLP package 4. A plurality of bumps 360 is disposed on the bottom surface 4b of the WLP package 4 to electrically connect the WLP package 4 with the board 40. The RDL structure 30 may further comprise at least one polymeric insulating layer 310 such as polyimide or epoxy, but not limited thereto. According to the illustrated embodiment, the interconnection scheme 300 may comprise copper post-passivation interconnection (Cu-PPI) scheme.

According to the illustrated embodiment, the chip package 1b further comprises a discrete passive device 130 embedded within the RDL structure 30. For example, the discrete passive device 130 may be mounted within a cavity that is recessed into the bottom surface 4b of the WLP package 4, but not limited thereto.

According to the illustrated embodiment, the discrete passive device 130 has two terminals 131 and 132, which may be electrically connected to ground/power points respectively, on the active surface 14a of the die 14 through the interconnection traces of the interconnection scheme 300.

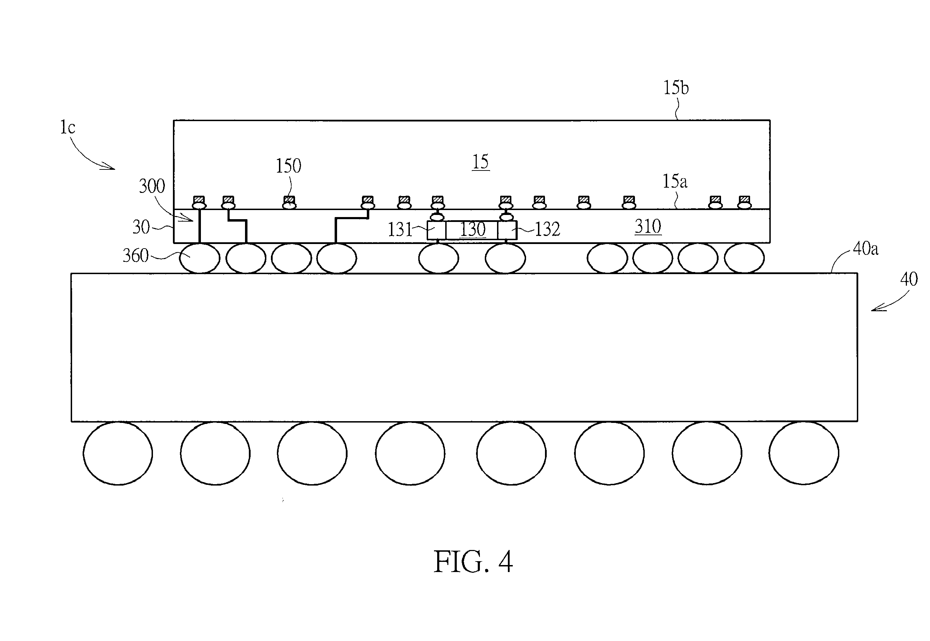

FIG. 4 is a schematic, cross-sectional diagram showing a flip-chip BGA (FCBGA) package according to still another embodiment of the invention, wherein like numeral numbers designate like regions, layers, or elements. As shown in FIG. 4, the FCBGA package 1c may comprise a single semiconductor die 15. An active surface 15a of the die 15 is flipped and is assembled face-down to a chip mounting surface 40a of a board 40 such as a packaging substrate or a printed circuit board.

According to the illustrated embodiment, a plurality of fine-pitch connection points 150 such as conductive pads or micro bumps may be distributed on the active surface 15a of the semiconductor die 15. An RDL structure 30 is disposed between the die 15 and the chip mounting surface 40a of the board 40. The RDL structure 30 fans out the fine-pitch connection points 150 to a looser pad pitch.

Likewise, interconnection scheme 300 may be fabricated in the RDL structure 30 to redistribute the plurality of fine-pitch connection points 150. A plurality of bumps 360 is disposed on the RDL structure 30 to electrically connect the semiconductor die 15 with the board 40. The RDL structure 30 may further comprise at least one polymeric insulating layer 310 such as polyimide or epoxy, but not limited thereto. According to the illustrated embodiment, the interconnection scheme 300 may comprise copper post-passivation interconnection (Cu-PPI) scheme.

According to the illustrated embodiment, the FCBGA package 1c further comprises a discrete passive device 130 embedded within the RDL structure 30. According to the illustrated embodiment, the discrete passive device 130 has two terminals 131 and 132, which may be electrically connected to ground/power points respectively, on the active surface 15a of the semiconductor die 15 through the interconnection traces of the interconnection scheme 300.

## Claims

1. A chip package, comprising:
a first die encapsulated by a molding compound;
a redistributed layer (RDL) structure on an active surface of the first die; and
a discrete passive device embedded within the chip package and situated in close proximity to a side edge of the first die.

2. The chip package according to claim 1, wherein the discrete passive device is embedded in the molding compound.

3. The chip package according to claim 1, wherein the discrete passive device is embedded in the RDL structure.

4. The chip package according to any of claims 1-3 further comprising a second die, wherein the first and second dies are arranged side-by-side and are both encapsulated by the molding compound.

5. The chip package according to claim 4, wherein the RDL structure is also disposed on an active surface of the second die.

6. The chip package according to claim 4, wherein an edge-to-edge distance between the first die and the second die is equal to or greater than 1000 micrometers.

7. The chip package according to claim 1, wherein the discrete passive device has a surface that is substantially flush with the active surface of the first die, wherein the RDL structure is also disposed on the surface.

8. The chip package according to claim 1, wherein the discrete passive device has two terminals electrically connected to ground pads and power pads respectively on the active surface of the first die through interconnection traces in the RDL structure.

9. The chip package according to claim 1, wherein a plurality of fine-pitch connection points is distributed on the active surface of the first die.

10. The chip package according to claim 1, wherein the RDL structure further comprise at least one polymeric insulating layer.

11. The chip package according to claim 1 further comprising a board having a chip mounting surface, wherein the active surface of the first die faces the chip mounting surface.

12. The chip package according to claim 9, wherein the RDL structure is disposed between the die and the chip mounting surface.
